# EUROPÄISCHE PATENTSCHRIFT

(11) **EP 0 515 712 B1**
(45) Veröffentlichungstag und Bekanntmachung des Hinweises auf die Patenterteilung: **10.04.1996**
(21) Anmeldenummer: 91108608.0
(22) Anmeldetag: 27.05.1991
(51) Int. Cl.: G01R 19/25, G01R 19/02, G01R 19/00

(54) **Schaltung zur Erfassung der Phasenströme in mehrphasigen Netzsystemen**
Phase-current measuring circuit in multiphase network systems
Dispositif de mesure des courants à phase dans des réseaux polyphasiques

(43) Veröffentlichungstag der Anmeldung: 02.12.1992
(73) Patentinhaber: Klöckner-Moeller GmbH, D-53115 Bonn (DE)
(72) Erfinder: Rast, Oliver, Dipl.-Ing., W-5309 Meckenheim (DE); Skupin, Johann, Dipl.-Ing., W-5210 Toisdorf (DE)

(56) Entgegenhaltungen:
- EP-A- 0 360 348
- DE-A- 3 638 935
- FR-A- 2 638 583
- GB-A- 2 152 680
- US-A- 4 025 849
- US-A- 4 713 608

## Beschreibung

Die Erfindung bezieht sich auf eine Schaltung zur Erfassung der Phasenströme in mehrphasigen Netzsystemen, bestehend aus mindestens einer in jede Phase geschalteten Stromfühler, dem Stromfühler nachgeschalteten Mitteln zur Gleichrichtung des vom vom Stromfühler ausgegebenen sinusförmigen Signals in ein pulsierendes Signal und Mitteln zur ohmschen Strom-Spannungs-Umsetzung, denen das pulsierende Signal zugeführt wird, welches dann als analoger Meßwert einer Meß- und Steuereinrichtung zur Auswertung angeboten wird.

In der DE-OS 36 38 935 wird eine Signalanpassungsschaltung für elektronische Auslöseschalter der gattungsgemäßen Art beschrieben. Diese Schaltung weist Stromabtastmittel zum Liefern von Stromwerten auf, die einen Stromfluß durch jede der drei Phasen eines elektrischen Netzsystems darstellen. Weiterhin sind Schaltmittel zum Unterbrechen des Stromflusses vorgesehen, die mit den drei Phasen verbunden sind, wenn die Stromwerte vorbestimmte Überstromwerte überschreiten. Ein Signalprozessor, der mit den Stromabtastmitteln und Schaltmitteln verbunden ist, vergleicht die Stromwerte mit den vorbestimmten Überstromwerten und betätigt die Schaltmittel auf Befehl. Weiter ist eine Einspeisung vorgesehen, die mit den Stromabtastmitteln zum Empfangen von Betriebsleistung verbunden ist und die die Schaltmittel und den Signalprozessor mit Betriebsleistung versorgt. Eine Bürde-Widerstandsschaltung, die mit den Stromabtastmitteln und dem Signalprozessor verbunden ist, liefert eine Spannungsdarstellung der Stromwerte, wobei die Bürde-Widerstandsschaltung drei getrennte Widerstände aufweist, die jeweils in eine der drei Phasen geschaltet sind, um eine getrennte Spannungsdarstellung für jede der drei Phasen zu liefern.

Nachteilig wirkt sich bei dieser Schaltung aus, daß für jede Phase ein Widerstand notwendig ist, dessen Meßsignale über getrennte Leitungen zu dem Signalprozessor transportiert werden. Die Auslöseeinheit benötigt in einem dreiphasigen Netzsystem für jede einzelne Phase eine Abtastschaltung, eine Schaltung zur Probeentnahme (Sampeln) und eine Schaltung zur Signalaufbereitung für den Signalprozessor.

Den Nachteil getrennter ohmscher Meßwiderstände weisen auch Anordnungen nach den Druckschriften US-PS 4 713 608 und FR-OS 2 638 583 auf, bei denen die Sekundärströme mehrerer Stromfühler entweder direkt oder mittels Pulsformerschaltungen zu separaten ohmschen Strom-Spannungs-Umsetzern für jede Phase geführt werden, um allerding darauf über Multiplexer zu von allen Phasen gemeinsam ausgenutzten weiteren Verarbeitungsanordnungen geführt zu werden.

Demgemäß stellt sich die Erfindung die Aufgabe, eine Schaltung, insbesondere für elektronische Auslöseschalter zu schaffen, die ohne den nach dem angegebenen Stand der Technik notwendigen Meßmittelaufwand auskommt und der Auslöseeinheit mittels eines Meßwiderstandes und einer Signalaufbereitungsschaltung das Ergebnis einer Strommessung jeder einzelnen Phase in einem mehrphasigen Netzsystem für einen bestimmbaren Meßzyklus übermittelt. Diese Aufgabe wird erfindungsgemäß dadurch gelöst, daß die Stromfühler mittels von der Meß- und Steuereinrichtung gesteuerten Schaltelementen innerhalb eines Meßzyklus in bestimmbaren zeitlichen Abständen kurzgeschlossen werden, daß die von den Phasens Strömen aller zu messenden Phasen abgeleiteten pulsierenden Signale von einem einzigen, die Mittel zur ohmschen Strom-Spannungs-Umsetzung darstellen den Meßwiderstand nacheinander erfaßt werden, wobei der zugehörige Stromfühler zur jeweiligen Abtastzeit nicht Kurzgeschlossen ist.

Vorteilhafte Weiterbildungen der Erfindung kennzeichnen die Unteransprüche.

Im folgenden wird die erfindungsgemäße Schaltung anhand einer beispielhaften Ausführung unter Zuhilfenahme der Zeichnung näher erläutert.

Es zeigen,
**Fig.1** die schematische Darstellung der erfindungsgemäßen Schaltung,
**Fig.2** ein Diagramm, das unter Verwendung der erfindungsgemäßen Schaltung die Meßabtastungen der drei Phasen innerhalb eines Meßzyklusses darstellt,
**Fig.3** ein Anwendungsbeispiel der erfindungsgemäßen Schaltung als Bestandteil einer Auslöseeinheit für den Bereich Motor- Und Anlagenschutz.

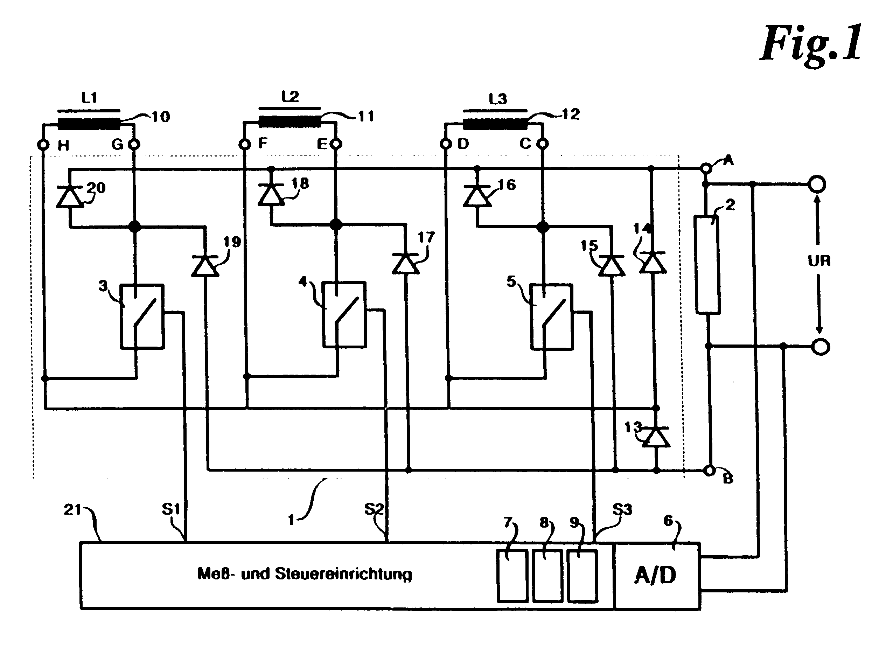

Die Fig.1 zeigt eine schematische Darstellung der erfindungsgemäßen Schaltung. Die drei, vor Überstrom zu schützenden oder auf ihre Stromstärke zu messenden und/oder zu überwachenden Phasen L1, L2, L3 werden jeweils mit einem Stromfühler (Stromwandler) W1, W2, W3 abgetastet. Den Stromwandlern ist jeweils ein Schaltelement 3, 4, 5 parallel geschaltet. Der die Sekundärwicklung der Stromwandler durchflutende Wechselstrom wird mittels der Dioden D13-D18 zu einem pulsierenden Gleichstrom gerichtet. Wären alle drei Schaltelemente 3, 4, 5, geöffnet, so würde immer nur der höchste Phasenstrom einen entsprechenden Spannungsabfall an dem Meßwiderstand 2 bewirken.

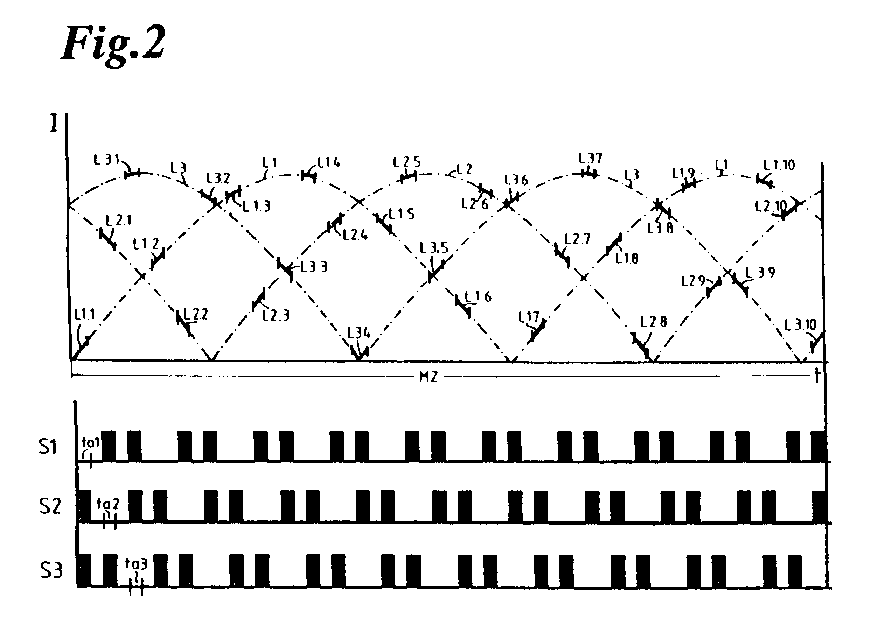

Erfindungsgemäß steuert die Meß- und Steuereinrichtung 1 die Schalterelemente 3, 4, 5 innerhalb eines bestimmbaren Meßzyklus (MZ) derart an, daß für ein Abtastzeitpunkt ta1-tan immer nur ein Schaltelement geöffnet ist und somit der entsprechende Wandlerstrom durch den Meßwiderstand fließt. Während des Abtastzeitpunktes ta1 wird der Strom der Phase L1 gemessen. Während des Abtastzeitpunktes ta2 wird der Strom der Phase L2 gemessen und daran anschließend der Phasenstrom der Phase 3 während des Abtastzeitpunktes ta3. Diese Meßfolge wiederholt sich in dem beispielhaft angegebenen Meßzyklus nach Fig.2 insgesamt zehnmal. Die Stromwandler der zwei Phasen, die innerhalb der Zeit eines Abtastzeitpunktes nicht gemessenen werden, sind mittels der Schaltelemente 3, 4, 5 die von der Steuereinrichtung 1 aktiviert werden, kuzgeschlossen.

Die Fig.2 zeigt ein Diagramm, das unter Verwendung der erfindungsgemäßen Schaltung die Meßabtastungen der drei Phasen innerhalb eines Meßzyklusses darstellt. Der Meßzyklus (MZ) jeder Phase weist in dieser beispielhaften Darstellung zehn Abtastzeitpunkte auf. Die Augenblickswerte der Abtastzeitpunkte L1.1 - L1.10 für die Phase L1 werden dem A/D-Wandler 6 zugeführt, der die Analogwerte digitalisiert und in dem Speicherbereich 7 ablegt.

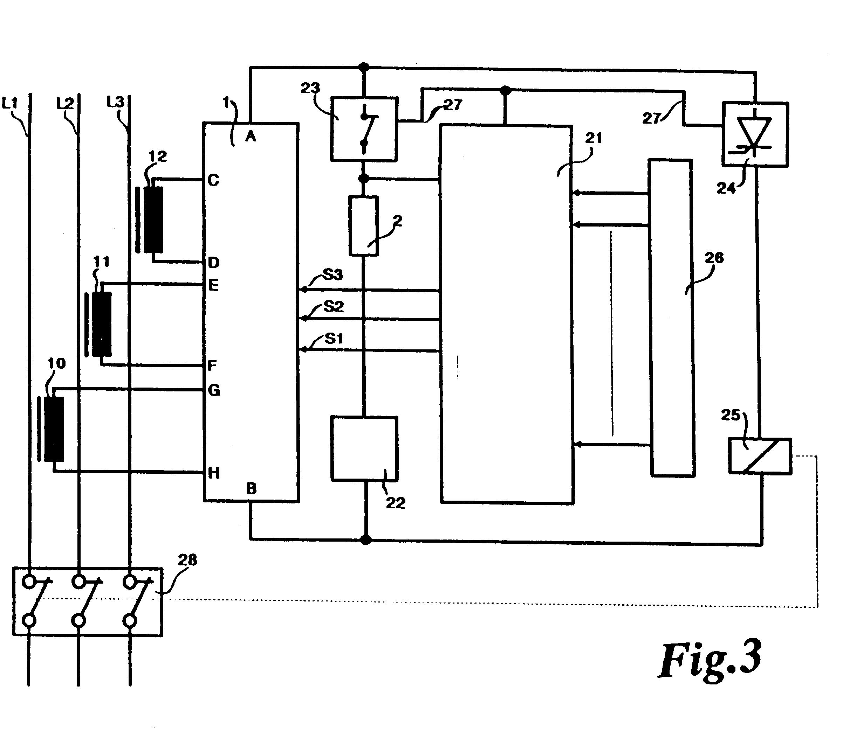

Gleiches gilt für die Augenblickswerte L2.1 - L2.10 für die Phase L2 und die Augenblickswerte L3.1 - L3.10 für die Phase L3. Dabei werden die Werte für die Phase L2 in digitalisierter Form in den Speicherbereich 8 und für die Phase L3 in den Speicherbereich 9 abgelegt. Die Auswertung bzw. Weiterverarbeitung dieser gespeicherten Werte ist von den Anwendungsforderungen abhängig und wird durch geeigneter Hardware realisiert. Beispielsweise kann der periodische Kurvenverlauf jeder Phase nachvollzogen werden. Durch die Messung der einzelnen Phasen ist eine echte Effektivwertberechnung durch einen geeigneten Mikroprozessor leicht realisierbar. Für die Erfindung ist nur die Meßwert- bzw. Signalerfassung und entsprechende Bereitstellung der erfaßten Meßsignale relevant. Der Meß- und Steuereinrichtung 1 wird die Taktfolge und deren Synchronität hardwaremäßig vorgegeben. In Fig.3 ist ein Anwendungsbeispiel der erfindungsgemäßen Schaltung als Bestandteil einer Auslöseeinheit für den Bereich Motor- Und Anlagenschutz dargestellt.

Die Meß- und Steuereinrichtung 21 liefert in diesem Fall nicht nur die augenblicklichen Stromwerte, die dem Meßwiderstand 2 entnommen werden, sondern auch die Betriebsleistung für die Energieversorgung der Auslöseschaltung. Ein Halbleiterschalter 23 ist im Normalbetrieb immer geschlossen. Die Auslösewerte werden von Einstellgliedern 26 vorgegeben und in einem Speicherbereich der di-gitalen Meß-und Steuereinheit 21 abgelegt. Die Einstellglieder sind geeignete Mittel zur Vorgabe der Auslöseparameter und können Schalter oder Potentiometer sein. Die Ausgänge S1, S2, S3 werden von der Meß- und Steuereinheit 21 derart gesteuert, daß im Augenblick der Messung nur eines der drei Schaltelemente 3, 4, 5 geöffnet bleibt. Die Dauer der Messung liegt im Mikrosekundenbereich. Für die Ermittlung der Effektivwerte sind lediglich zehn Messungen pro Periode und Phase notwendig. Zusätzlich wird das Summensignal (alle Schaltelemente 3, 4, 5 offen) in einer bestimmten Zeitdauer auf Kurzschlußstrom überwacht. Mit dem Auslösesignal 27 wird der Halbleiterschalter 23 geöffnet und die Energieversorgung 22 inaktiv. Gleichzeitig bewirkt das Auslösesignal 27 das Durchschalten des Thyristors 24. Damit wird erreicht, daß die gesamte Energie aus allen Stromwandlern 10, 11, 12 durch die Auslösespule 25 genutzt werden kann und der Leitungsunterbrecher 28 schnell öffnet und somit den Stromfluß der Phasen R, S, T unterbricht.

## Patentansprüche

1. Schaltung zur Erfassung der Phasenströme in mehrphasigen Netzsystemen, bestehend aus mindestens einem in jede Phase (L1, L2, L3) geschalteten Stromfühler (10, 11, 12), dem Stromfühler (10, 11, 12) nachgeschalteten Mitteln zur Gleichrichtung (13 ... 20) des vom Stromfühler (10, 11, 12) ausgegebenen sinusförmigen Signals in ein pulsierendes Signal und Mitteln zur ohmschen Strom-Spannungs-Umsetzung (2), denen das pulsierende Signal zugeführt wird, welches dann als analoger Meßwert einer Meß- und Steuereinrichtung (21) zur Auswertung angeboten wird, **dadurch gekennzeichnet**, daß die Stromfühler (10, 11, 12) mittels von der Meß- und Steuereinrichtung (21) gesteuerten Schaltelementen (3, 4, 5) innerhalb eines Meßzyklus (MZ) in bestimmbaren zeitlichen Abständen kurzgeschlossen werden, daß die von den Phasenströmen aller zu messenden Phasen (L1, L2, L3) abgeleiteten pulsierenden Signale von einem einzigen, die Mittel zur ohmschen Strom-Spannungs-Umsetzung darstellenden Meßwiderstand (2) nacheinander erfaßt werden, wobei der zugehörige Stromfühler (10, 11, 12) zur jeweiligen Abtastzeit (tal, ta2, ta3) nicht kurzgeschlossen ist.

2. Schaltung zur Erfassung der Phasenströme in mehrphasigen Netzsystemen nach Anspruch 1, **dadurch gekennzeichne**t, daß die Meß- und Steuereinrichtung (21) für jede Phase (L1, L2, L3) einen eigenen Speicherbereich aufweist, in dem die Momentanmeßwerte jeder Phase innerhalb eines Meßzyklus (MZ) abgelegt werden.

3. Schaltung zur Erfassung der Phasenströme in mehrphasigen Netzsystemen nach Anspruch 2, **dadurch gekennzeichnet**, daß die Meß- und Steuereinrichtung (21) einen Analog-Digitalwandler (6) aufweist, der die Momentanmeßwerte der Phasen (L1, L2, L3) in für die Abspeicherung geeignete Signale umformt.

4. Schaltung zur Erfassung der Phasenströme in mehrphasigen Netzsystemen nach Anspruch 1, **dadurch gekennzeichnet**, daß die Schaltelemente (3, 4, 5) Halbleiterschalter sind.

## Claims

1. Circuit allowing the registration of phase currents in polyphase network systems, consisting of at least one current sensor (10, 11, 12) connected to every phase (L1, L2, L3), of means connected on the load side of the current sensor (10, 11, 12) and allowing the rectification (13 ... 20) of the sinusoidal signal emitted by the current sensor (10, 11, 12) into a pulsating signal, and of means allowing ohmic current-voltage conversion (2) to which the pulsating signal is fed and which signal is then presented to a measurement and control device (21) for evaluation, in which the current sensors (10, 11, 12) are short-circuited within one measurement cycle (MZ) at determinable time intervals by means of switching elements (3, 4, 5) controlled by the measurement and control device (21), in which the pulsating signals derived from the phase currents of all phases (L1, L2, L3) to be measured are registered one after the other by a single measuring resistor (2), representing the means allowing ohmic current-voltage conversion, while the corresponding current sensor (10, 11, 12) is not short-circuited at the corresponding sampling time (ta1, ta2, ta3).

2. Circuit allowing the registration of phase currents in polyphase network systems as claimed in claim 1, wherein the measurement and control device (21) has a particular memory area for every phase (L1, L2, L3), storing the instantaneous measuring values obtained for every phase within one measurement cycle (MZ).

3. Circuit allowing the registration of phase currents in polyphase network systems as claimed in claim 2, wherein the measurement and control device (21) presents an analogue-to-digital converter (6) which converts the instantaneous measuring values of phases (L1, L2, L3) into signals suitable for storage.

4. Circuit allowing the registration of phase currents in polyphase network systems as claimed in claim 1, wherein the switching elements (3, 4, 5) are semiconductor switches.

## Revendications

1. Montage pour la détection des courants de phase dans des systèmes de réseaux polyphasés, composé au moins d'un détecteur de courant (10, 11, 12) relié pour chaque phase (L1, L2, L3), du moyen de redressement (13 ...20) intercalé à la suite du détecteur de courant(10, 11, 12), pour le redressement du signal sinusoidal sorti du détecteur de courant (10, 11, 12) en un signal ondulé, et de moyens de conversion de tension de courant ohmique (2), auxquels le signal ondulé est amené, ledit signal étant ensuite offert en tant que valeur de mesure analogique à un dispositif de mesurage et de commande (21) pour évaluation, **caractérisé en ce que** les détecteurs de courant (10, 11, 12) sont mis en court-circuit au moyen des éléments de circuit (3, 4, 5) commandés par le dispositif de commande (21), à l'intérieur d'un cycle de mesurage (MZ) à intervalles temporels déterminables, et en ce que les signaux ondulés dérivés des courants de phase de toutes les phases à mesurer (L1, L2, L3) sont détectés l'un après l'autre par une résistance série (2) unique, présentant les moyens de conversion de tension de courant ohmique, ce à l'occasion de quoi le détecteur de courant associé (10, 11, 12) n'est pas mis en court-circuit au temps de balayage correspondant (ta1, ta2, ta3).

2. Montage pour la détection des courants de phase dans des systèmes de réseaux polyphasés selon la revendication 1, **caractérisé en ce que** le dispositif de mesurage et de commande (21) présente une mémoire de mémorisation propre à chaque phase (L1, L2, L3), mémoire dans laquelle sont déposées les valeurs de mesure instantanées de chaque phase à l'intérieur d'un cycle de mesurage (MZ).

3. : Montage pour la détection des courants de phase dans des systèmes de réseaux polyphasés selon la revendication 2, **caractérisé en ce que** le dispositif de mesurage et de commande (21) présente un transformateur analogique-digital (6), convertissant les valeurs de mesure instantanées des phases (L1, L2, L3) en signaux appropriés à la mémorisation.

4. Montage pour la détection des courants de phase dans des systèmes de réseaux polyphasés selon la revendication 1, **caractérisé en ce que** les éléments de circuit (3, 4, 5) sont des commutateurs semi-conducteurs.
